Europäisches Patentamt

European Patent Office

Office européen des brevets

(19)

(11) Numéro de publication : **0 030 497**
**B1**

(12) **FASCICULE DE BREVET EUROPÉEN**

(45) Date de publication du fascicule du brevet :
15.04.87

(51) Int. Cl.⁴ : **G 01 R 31/34**

(21) Numéro de dépôt : **80401710.1**

(22) Date de dépôt : **01.12.80**

(54) Dispositif de détermination du couple fourni par un moteur électrique asynchrone.

(30) Priorité : 07.12.79 FR 7930093

(43) Date de publication de la demande :
17.06.81 Bulletin 81/24

(45) Mention de la délivrance du brevet :
15.04.87 Bulletin 87/16

(84) Etats contractants désignés :
BE CH DE GB IT LI LU NL SE

(56) Documents cités :
US-A- 3 930 409
BOURNE R.: "Electrical rotating machine testing",
Iliff Editor, 1969, Londres, GB.
"Leitfaden der Elektrotechnik", Band II, Teil 2,
"Wechselstrommaschinen", de Moeller-Werr, édité
par Teubner Verlagsgesellschaft, Stuttgart 1954, p.
60,61
Erläuterungen zu den Regeln für elektrische Maschinen, VDE 0530/3.59 2, Verbesserte Auflage 1962, VDE-
Verlag GmbH, Berlin 1962, p. 51,52
Encyclopédie des Sciences Industrielles Quillet,
Librairie Quillet, Paris 1973, p. 568

(73) Titulaire : **LA TELEMECANIQUE ELECTRIQUE**
**33 bis, avenue du Maréchal Joffre**
**F-92000 Nanterre (FR)**

(72) Inventeur : **Bejot, Emile**
**11, Hameau ND des Selves**
**F-06510 Carros (FR)**
Inventeur : **Filiaggi, Adriano**
**68, Chemin de St. Claude**
**F-06600 Antibes (FR)**
Inventeur : **Pillais, Jacky**
**31, Square St. Exupéry**
**F-92500 Rueil Malmaison (FR)**
Inventeur : **Planche, Jean-Pierre**
**Bat. 4, Rue Henri Prou**
**F-78340 Les Clayes Sous Bois (FR)**

(74) Mandataire : **Marquer, Francis**
**CABINET MOUTARD 35, avenue Victor Hugo Rési-**
**dence Champfleury**
**F-78180 Voisins-le-Bretonneux (FR)**

## Description

L'invention a pour objet un dispositif de détermination du couple fourni par un moteur électrique asynchrone.

Elle s'applique plus particulièrement à la détection des surcharges et/ou des sous-charges des moteurs asynchrones, en vue de leur surveillance et/ou de la protection des installations mécaniques qui en sont équipées, ou à l'asservissement du couple.

Les procédés connus (mesure de $\Phi$ ou de cos $\Phi$ ; mesure de la vitesse du moteur) ne sont pas très fiables et ne donnent pas une image fidèle du couple sur l'arbre, indépendamment des variations du réseau d'alimentation.

Il est connu en principe, en particulier par l'Encyclopédie de Sciences Industrielles, éditée en 1973 par la Librairie Aristide Quillet, Paris, page 568 et par le livre « Erläuterungen zu den Regeln für elektrische Maschinen », édité par VDE-Verlag GmbH, Berlin 1962, pages 51 et 52, de retrancher de la puissance absorbée mesurée les pertes par effet Joule mesurées. Il est connu également que les pertes « fer » dépendent de la tension.

A partir de ces connaissances théoriques, la Demanderesse a imaginé un dispositif pratique de détermination continue de la puissance mécanique utile d'un moteur asynchrone. Un tel dispositif fournit en permanence une image du couple fourni par le moteur en fonctionnement.

L'invention propose de déterminer le couple fourni par la machine en mesurant, par un procédé connu, la puissance absorbée au réseau et en en déduisant l'ensemble des pertes, à savoir : pertes par effet Joule dans les enroulements du stator ; pertes « fer » dans les circuits magnétiques du stator ; pertes mécaniques et autres pertes à vide (les pertes « fer » au rotor étant considérées comme négligeables).

Suivant l'invention, le dispositif de mesure qui effectue la détermination de la puissance mécanique utile est caractérisé par des moyens de déterminer la puissance moyenne absorbée au réseau par un organe de mesure du courant dans une phase, par élaboration d'une tension simple à partir de tensions entre phases et intégration du produit dudit courant par ladite tension, des premiers moyens de retrancher dudit produit, avant ladite intégration, une quantité fonction du carré dudit courant ; des seconds moyens de retrancher dudit produit, avant ladite intégration, une quantité fonction de ladite tension et des troisièmes moyens de retrancher dudit produit, avant ladite intégration, une quantité telle que, lorsque le moteur tourne à vide, le résultat de ladite intégration soit nul.

On notera que les diverses grandeurs représentant les pertes sont retranchées à un niveau où l'intégration du produit n'a pas encore été effectuée, ce qui permet d'éviter un circuit encombrant.

Suivant un mode d'exécution préféré, le dispositif comporte en outre des quatrièmes moyens de retrancher, du résultat de ladite intégration, une fraction dudit résultat variable en fonction du temps suivant une loi exponentielle.

Les premiers moyens retranchent, de la puissance absorbée au réseau, les pertes Joule au stator, les seconds moyens en retranchent les pertes fer et les troisièmes moyens, les pertes à vide, tandis que les quatrièmes moyens corrigent l'effet des premiers en tenant compte de l'augmentation des pertes Joule due à l'échauffement des enroulements au cours du fonctionnement du moteur.

Les particularités, ainsi que les avantages de l'invention, apparaîtront clairement à la lumière de la description détaillée qui suit.

Au dessin annexé :

La figure 1 représente schématiquement un dispositif de détermination du couple d'un moteur asynchrone conforme à un mode d'exécution préféré de l'invention et associé à des organes à seuil assurant une surveillance et,

La figure 2 est le schéma d'un mode d'exécution préféré des quatrièmes moyens susvisés.

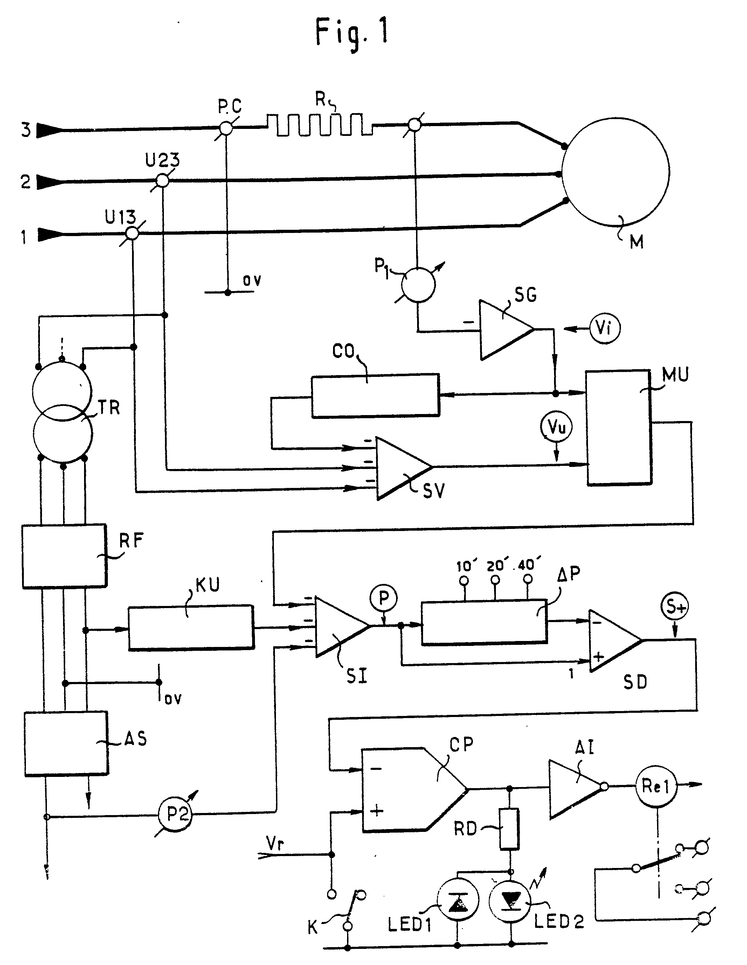

A la figure 1, on a représenté un moteur M du type asynchrone triphasé à cage. Aux bornes d'une résistance R, on prélève une tension image du courant sur une phase 3. Cette tension est appliquée, par l'intermédiaire d'un potentiomètre de réglage de gain $P_1$, à un amplificateur opérationnel SG monté en inverseur, dont la sortie est reliée à une entrée d'un multiplicateur MU. L'autre entrée de ce multiplicateur est reliée à la sortie d'un sommateur-inverseur SV à trois entrées. Une première entrée de SV est reliée à la sortie de SG par l'intermédiaire d'un organe compensateur CO qui injecte dans SV une fraction de la tension de sortie de SG, dont la fonction sera expliquée plus loin. Une seconde entrée est reliée à la phase 2 ; une troisième entrée est reliée à la phase 1. Le point commun (OV) est pris sur la phase 3, ce qui permet d'appliquer sur la deuxième entrée la tension $U_{23}$ et, sur la troisième entrée, la tension $U_{13}$.

A la sortie de SV, on recueillerait, en l'absence de l'injection, à la première entrée de SV, d'une fraction de la tension de sortie de SG, une image $-V_u \sin \omega t$ de trois fois la tension simple, tandis qu'à la sortie de SG on a une image : $-V_i \sin(\omega t - \Phi)$ du courant I dans la phase restante, $\Phi$ étant le glissement de phase du courant par rapport à la tension.

En intégrant le produit effectué par MU de ces deux tensions-images dans un sommateur-inverseur SI, on obtiendrait donc, selon un procédé d'ailleurs connu en soi, une tension proportionnelle à la puissance active absorbée $V_i \cdot V_u \cdot \cos \Phi$.

$P_1$ règle le gain de SG pour tenir compte du fait que le courant pourra varier par exemple entre 0,5A et 5A, et effectuer une mise en échelle.

L'organe compensateur CO, propre à un montage de l'invention et qui est avantageusement un potentiomètre, permet de tenir compte des pertes par effet Joule dans les enroulements du stator. En effet, une fraction de la tension de sortie de SG, proportionnelle à I, se trouvant réinjectée dans MU, donc multipliée par I, c'est finalement une quantité proportionnelle à $I^2$ qui est retranchée de la puissance active absorbée. La sortie de MU est injectée dans une première entrée d'un amplificateur opérationnel SI monté en sommateur-intégrateur.

Selon une autre particularité, l'amplificateur opérationnel SI, outre sa première entrée, reliée à la sortie de MU, possède une seconde entrée, reliée à un organe de compensation KU et une troisième entrée reliée à un potentiomètre $P_2$.

L'organe KU est alimenté par la tension U entre les phases 1 et 2, prélevée au moyen d'un transformateur TR et redressée et filtrée en RF. Cette tension après stabilisation par un circuit AS, sert d'alimentation stabilisée aux différents organes du montage, y compris le potentiomètre $P_2$.

L'organe KU fournit, soit une tension proportionnelle à U (il s'agit alors d'un simple potentiomètre), soit une fonction plus complexe de U (tension en $U^n$ par exemple), suivant que les variations du réseau sont ou non suffisantes pour que l'on sorte ou non de la plage de saturation, les circuits magnétiques du stator. Cette tension de correction compense les pertes fer dans lesdits circuits.

Le potentiomètre $P_2$ retranche de la puissance recueillie à la sortie de SI une quantité que l'on règle pour obtenir, comme on l'expliquera dans la suite, une puissance de sortie nulle lorsque le moteur tourne à vide de façon à compenser les pertes mécaniques (et autres pertes à vide). Cette compensation reste valable lorsque le moteur est en charge ; toutefois, comme les pertes mécaniques peuvent évoluer lentement, il faut réajuster de temps en temps ce « zéro mécanique », en agissant sur le réglage de $P_2$.

La sortie de SI est reliée directement à l'entrée positive d'un soustracteur SD et elle est reliée à l'entrée négative de SD par l'intermédiaire d'un organe de compensation ΔP qui y injecte une fraction ΔP de la puissance P de sortie de SI, fraction variable en fonction du temps suivant une loi exponentielle. La sortie S du soustracteur est donc P — ΔP.

L'intérêt de cette compensation est le suivant : lorsque le moteur est froid, la résistance $R_0$ des enroulements du stator a une valeur $R_0$, relativement faible et la compensation apportée par CO, destinée à tenir compte des pertes par effet Joule est excessive. Au fur et à mesure que le moteur s'échauffe, la résistance des enroulements augmente et il faut donc apporter une compensation supplémentaire.

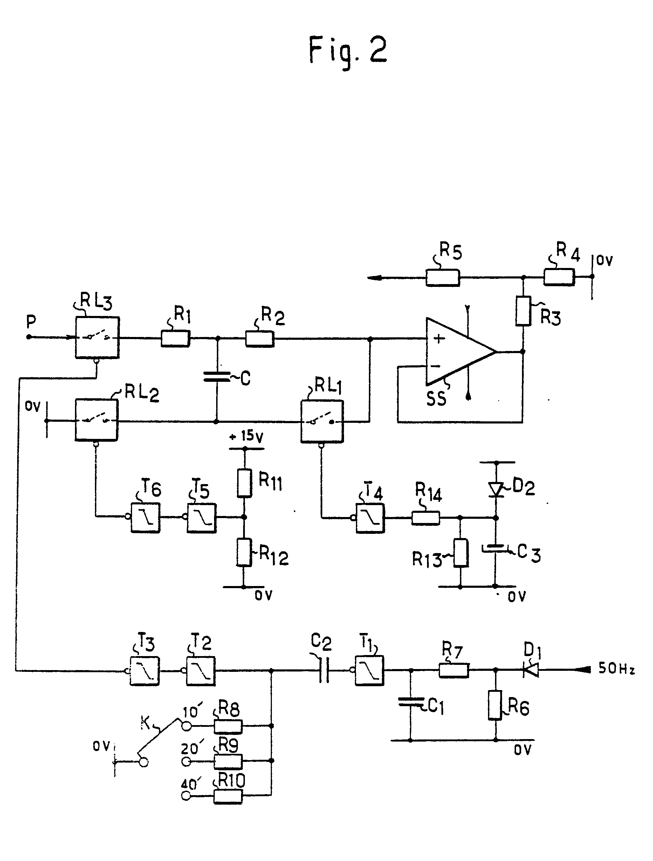

Le circuit ΔP, dont un mode d'exécution préféré sera décrit en se référant à la figure 2, fournit une tension $ΔP=KP (1 — e^{-t/RC})$, RC étant une constante de temps de longue durée, programmable par l'utilisateur, par échelons de 10 min par exemple (bornes marquées 10', 20' et 40'), K étant un coefficient de proportionnalité compris entre 0 et 1.

On va maintenant expliquer comment s'effectue le réglage de « zéro mécanique » mentionné ci-dessus.

La sortie du soustracteur SD est reliée à une entrée d'un comparateur à seuil CP dont l'autre entrée reçoit une tension de référence $V_r$. La sortie de CP est reliée, d'une part, à l'entrée d'un inverseur AI dont la sortie commande un relais $Re^i$ destiné à signaler par exemple une surcharge, d'autre part, par l'intermédiaire d'une résistance $R_D$ à deux diodes photo-émettrice $LED_1$, $LED_2$ montées tête-bêche. Un commutateur K permet de mettre à la masse ou à la tension de référence, l'entrée positive de CP.

Lorsque le commutateur K est fermé, CP bascule au voisinage d'une tension nulle appliquée sur son entrée négative. On effectue un réglage approprié du potentiomètre $P_2$ pour obtenir le seuil de changement d'allumage des deux diodes alors que le moteur tourne à vide.

Il est clair qu'en fonctionnement normal du moteur, la sortie de SD représente l'image du couple fourni par le moteur (puissance active absorbée moins les pertes).

Lorsque le commutateur K est ouvert, CP transmet à AI les dépassements de la valeur de consigne (définie par Vr) du couple du moteur. Le montage décrit effectue donc une surveillance de ce fonctionnement du moteur.

A la figure 2, on a représenté un circuit de charge d'un condensateur C, par la tension de sortie du sommateur inverseur SI de la figure 1, à travers un commutateur analogique $RL_3$ et une résistance $R_1$. La charge de ce condensateur est transmise, par une résistance $R_2$, à l'entrée positive d'un amplificateur opérationnel SS, dont l'entrée négative est reliée à la sortie. Cette dernière attaque l'entrée négative du soustracteur SD de la figure 1 par l'intermédiaire d'un pont diviseur par vingt constitué de résistances $R_3$, $R_4$ et $R_5$.

L'entrée positive de SS est reliée à la masse par l'intermédiaire de deux commutateurs analogiques $RL_1$ et $RL_2$, dont le point commun est relié à la borne du condensateur C non reliée aux résistances $R_1$, $R_2$.

Le commutateur analogique $RL_3$ reçoit des impulsions de commande de sa fermeture, engendrées à partir du réseau de 50 Hz, par redressement d'une alternance au moyen d'une diode $D_1$ puis filtré, (en ce qui concerne les parasites du réseau) par une cellule composée de deux résistances $R_6 — R_7$ et d'un condensateur $C_1$. Une bascule $T_1$ transforme les demi-ondes positives redressées fournies par cette cellule en créneaux rectangulaires ayant une largeur correspondant à une durée de 10 ms. Ces créneaux sont différenciés par un circuit comprenant un condensateur $C_2$ et l'une des résistances $R_8$, $R_9$, $R_{10}$, suivant la position 10', 20' ou 40' d'un cavalier de commutation K relié à la masse.

Il en résulte la génération d'impulsions correspondant aux fronts montant des créneaux et de durée ajustable entre 30 et 200 µs environ. Ces impulsions sont mises en forme par deux bascules $T_2$ et $T_3$.

En cas de coupure du réseau, un condensateur réservoir (non figuré), normalement chargé par l'alimentation stabilisée (AS, figure 1) fournit une tension de 15 volts.

Le commutateur analogique $RL_2$, normalement fermé quand le réseau est présent (si bien que C a alors une électrode à la masse), est ouvert à la coupure du réseau, sous la commande de la tension (marquée + 15 V au dessin) fournie par le condensateur réservoir, prélevée sur un pont diviseur $R_{11}$, $R_{12}$ et mise en forme par deux bascules $T_5$ et $T_6$. Il en résulte que le condensateur C ne peut alors se décharger dans l'amplificateur SS, celui-ci n'est alors pas alimenté, une telle décharge doit être évitée.

A la mise sous tension normale du dispositif, un condensateur $C_3$ se charge à travers une diode $D_2$. En cas de coupure de réseau, $C_3$ se décharge dans une résistance $R_{13}$, en un temps de l'ordre de 70 sec., au bout duquel un front raide, mis en forme par une bascule $T_4$, ferme le commutateur analogique $RL_1$ normalement ouvert. Il en résulte que le condendateur C se décharge à travers $RL_1$ dans la résistance $R_2$ (de valeur beaucoup plus faible que $R_1$). La constante de temps de 70 sec. permet au condensateur C de garder la mémoire de l'échauffement si un arrêt puis un redémarrage rapproché de l'installation sont nécessaires.

En fonctionnement normal, le condensateur C se charge pendant la durée des impulsions appliquées à $RL_3$, à travers $RL_3$, la résistance $R_1$ et $RL_2$ (alors fermé). Entre deux impulsions, le condensateur C conserve pratiquement sa charge, SS ayant une impédance d'entrée très grande et $RL_1$ étant ouvert, si bien qu'aucune voie de décharge n'existe. Il en résulte finalement que la constante de temps de charge de C est beaucoup plus grande que celle qui serait déterminée par le produit $R_1C$ (elle est 10, 20 ou 40 min dans l'exemple décrit).

L'amplitude de la tension aux bornes de C est mesurée par l'amplificateur SS, qui joue le rôle de suiveur et divisée par vingt : c'est-à-dire, finalement que la fraction ∆P varie exponentiellement entre les limites 0 et 5 % de P.

La réalisation pratique du montage illustré par les figures 1 et 2 est à la portée de l'homme de l'art. A titre d'exemple, SS sera un amplificateur opérationnel à transistor à effet de champ, modèle LF 13741N, SD un amplificateur différentiel à gain unité, modèle LM 301A ; CP un amplificateur opérationnel modèle LM 301A, SG un amplificateur opérationnel modèle LM 301A, SV un amplificateur opérationnel modèle LM 301A, jouant le rôle de sommateur inverseur, SI un amplificateur opérationnel modèle LM 301A, jouant le rôle de sommateur et de semi-intégrateur, MU un multiplicateur à quatre quadrants constitué par le circuit énergie RC 4200A de la Société « Raytheon ». $RL_1$ à $RL_3$ peuvent être constitués de relais statiques bidirectionnels constitués de circuits intégrés CMOS 4016.

## Revendications

1. Dispositif de détermination de la puissance mécanique utile fournie par un moteur électrique asynchrone (M), caractérisé par des moyens (SV, MU, SG, SI) de déterminer la puissance moyenne absorbée au réseau par un organe (R) de mesure du courant dans une phase, par élaboration d'une tension simple à partir de tensions entre phases ($U_{13}$, $U_{23}$) et intégration du produit dudit courant par ladite tension, des premiers moyens (CO, SV) de retrancher dudit produit, avant ladite intégration, une quantité fonction du carré dudit courant ; des seconds moyens (TR, RF, KU) de retrancher dudit produit, avant ladite intégration, une quantité fonction de ladite tension et des troisièmes moyens (AS, $P_2$) de retrancher dudit produit, avant ladite intégration, une quantité telle que, lorsque le moteur tourne à vide, le résultat de ladite intégration soit nul.

2. Dispositif selon la revendication 1, caractérisé par des quatrièmes moyens (∆P) de retrancher, du résultat de ladite intégration, une fraction dudit résultat variable en fonction du temps suivant une loi exponentielle.

3. Dispositif suivant la revendication 2, caractérisé en ce que lesdits quatrièmes moyens (∆P) comportent un condensateur chargé (C), à travers une résistance ($R_1$), par la tension représentative dudit résultat d'intégration, pendant la durée d'impulsions périodiques, à la fréquence du réseau, appliquées à un premier commutateur ($RL_3$) analogique en série avec ladite résistance.

4. Dispositif suivant la revendication 3, caractérisé par un deuxième et un troisième commutateur analogique ($RL_2$, $RL_1$), reliant respectivement la borne du condensateur non reliée au premier commutateur analogique à la masse et par l'intermédiaire d'une autre résistance ($R_2$), à l'autre borne du condensateur, le second commutateur analogique ($RL_2$), normalement fermé, s'ouvrant en cas de coupure du réseau et ledit troisième commutateur ($RL_1$) analogique, normalement ouvert, se fermant après un délai déterminé après la coupure du réseau.

5. Dispositif selon l'une des revendications 1 à 4, caractérisé en ce que lesdits premiers moyens sont constitués par un potentiomètre (CO) relié à la sortie de l'organe de mesure (R) dudit courant et des moyens (SV) de retrancher, à l'entrée d'un organe multiplicateur (MU) qui effectue ledit produit, la tension de sortie dudit potentiomètre de ladite tension simple.

6. Dispositif selon l'une des revendications 1 à 5, caractérisé en ce que les deuxièmes moyens comportent un potentiomètre (KU) alimenté par ladite tension entre phases, après redressement et des moyens de soustraire dans un organe soustracteur-intégrateur (SI) une fonction de ladite tension du produit issu de l'organe multiplicateur (MU).

7. Dispositif selon l'une des revendications 1 à 6, caractérisé en ce que les troisièmes moyens comportent un potentiomètre (P₂) qui prélève une fraction d'une tension constante et des moyens de soustraire dans l'organe soustracteur-intégrateur (SI) ladite tension constante du produit issu de l'organe multiplicateur (MU).

8. Dispositif selon l'une des revendications 1 à 7, caractérisé en ce que le résultat de l'intégration, corrigé de l'action des quatrièmes moyens, est comparée au potentiel de la masse dans un organe de comparaison (CP) muni à sa sortie d'un organe de signalisation (LED₁, LED₂) de la valeur zéro dudit résultat corrigé.

9. Dispositif selon la revendication 8, caractérisé en ce que ledit organe de comparaison (CP) est, en outre, agencé pour comparé le résultat de l'intégration à une tension de référence (Vᵣ).

**Claims**

1. Device for the determination of the useful mechanical power supplied by an asynchronous electric motor (M), characterized by means (SV, MU, SG, SI) for determining the mean power absorbed from the supply mains by a means (R) for measuring the current in one phase, by elaborating a single phase voltage from the voltages between two phases ($U_{13}$, $U_{23}$) and by integrating the product of said current and said voltage, and first means (CO, SV) for subtracting from said product, before said integration, a quantity which is a function of the square of said current, second means (TR, RF, KU) for subtracting from said product, before said integration, a quantity which is a function of said voltage, and third means (AS, P₂) for subtracting from said product, before said integration a quantity selected such that, when the motor is rotating under off-load conditions, the result of said integration is zero.

2. Device according to claim 1, characterized by fourth means (Δ, P) for subtracting, from the result of said integration, a fraction of said result variable as a function of time according to an exponential law.

3. Device according to claim 2, characterized in that said fourth means (Δ, P) comprise a capacitor (C) which is charged, through a resistor (R₁), by a voltage representative of said result of integration for the duration of periodic pulses, at the supply frequency, applied to a first analog switch (RL₃) connected in series with said resistor.

4. Device according to claim 3, characterized by a second and a third analog switch (RL₂, RL₁) respectively connecting the terminal of the capacitor which is not connected to the first analog switch to earth and, by means of a further resistor (R₂), to the other terminal of the capacitor, the second analog switch (RL₂), which is normally closed, being opened in case of a cutting of the supply mains and said third analog switch (RL₁), normally open, being closed after a predetermined delay from the interruption of the supply.

5. A device according to one of claims 1 to 4, characterized in that said first means are formed by a potentiometer (CO) connected to the output of the means (R) for measuring said current, and means (SV) for subtracting, at the input of a multiplier device (MU) for effecting said product, the output voltage of said potentiometer from said single phase voltage.

6. Device according to one of claims 1 to 5, characterized in that said second means comprise a potentiometer (KU) fed by said voltage between two phases, after rectification, and means for subtracting, in a subtractor-integrator device (SI), a function of said voltage from the product provided by said multiplier device (MU).

7. A device according to one of claims 1 to 6, characterized in that the third means comprise a potentiometer (P₂) which takes off a fraction of a constant voltage, and means for subtracting, in the subtractor-integrator device (SI), said constant voltage from the product provided by the multiplier device (MU).

8. Device according to one of claims 1 to 7, characterized in that the result of the integration, as corrected by the action of the fourth means, is compared with earth potential in a comparator device (CP) provided at its output with means (LED₁, LED₂) for indicating the zero value of said corrected result.

9. Device acccording to claim 8, characterized in that said comparator device (CP) is furthermore adapted to compare the result of the integration with a reference voltage (V₂).

**Patentansprüche**

1. Vorrichtung zur Bestimmung der von einem elektrischen Asynchronmotor (M) gelieferten mechanischen Nutzleistung, gekennzeichnet durch Mittel (SV, MU, SG, SI), um die durch ein Organ (R) zur Messung des Stroms in einer Phase durchschnittliche vom Netz aufgenommene Energie zu bestimmen, durch Erzeugung einer Einphasenspannung ausgehend von Interphasenspannungen ($U_{13}$, $U_{23}$), und die Integration des Produktes aus besagtem Strom und besagter Spannung, durch erste Mittel (CO, SV), um von besagtem Produkt, vor besagter Integration, ein vom Quadrat des besagten Stroms abhängiges Quantum abzuziehen ; zweite Mittel (TR, RF, KU), um von besagtem Produkt, vor besagter Integration, ein von besagter Spannung abhängiges Quantum abzuziehen, und dritte Mittel (AS, P₂), um von besagtem Produkt, vor besagter Integration, ein so gewähltes Quantum abzuziehen, dass, wenn der Motor unbelastet läuft, das Ergebnis besagter Integration gleich Null ist.

2. Vorrichtung nach Anspruch 1, gekennzeichnet durch vierte Mittel (Δ, P), um vom Ergebnis besagter Integration einen Bruchteil des besagten Ergebnisses abzuziehen, der, einem exponentiellen Gesetz folgend, zeitabhängig veränderlich ist.

3. Vorrichtung nach Anspruch 2, dadurch gekennzeichnet, dass zu besagten vierten Mitteln (Δ, P) ein Kondensator (C) gehört, welcher, durch einen Widerstand ($R_1$) mit der für das besagte Integrationsergebnis repräsentativen Spannung aufgeladen wird, während der Dauer periodischer Impulse mit Netzfrequenz, die an einen ersten in Reihe mit besagtem Widerstand geschalteten Analogschalter ($RL_3$) angelegt werden.

4. Vorrichtung nach Anspruch 3, gekennzeichnet durch einen zweiten und einen dritten Analogschalter ($RL_2$, $RL_1$), die jeweils die nicht an den ersten Analogschalter angeschlossene Kondensatorklemme mit der Masse verbindet und, mittels eines weiteren Widerstandes ($R_2$), mit der anderen Kondensatorklemme, wobei der zweite Analogschalter ($RL_2$), der normalerweise geschlossen ist, bei Stromausfall geöffnet wird und besagter dritter Analogschalter ($RL_1$), der normalerweise geöffnet ist, nach einer bestimmten Zeitdauer des Stromausfalls geschlossen wird.

5. Vorrichtung nach einem der Ansprüche 1 bis 4, dadurch gekennzeichnet, dass besagte erste Mittel von einem Potentiometer (CO) gebildet werden, welcher an den Ausgang des Mittels (R) zur Messung des besagten Stroms angeschlossen ist, und Mitteln (SV), um, am Eingang von Multiplikationsmitteln (MU), welche das besagte Produkt erarbeiten, die Ausgangsspannung des besagten Potentiometers von besagter Einphasenspannung abzuziehen.

6. Vorrichtung nach einem der Ansprüche 1 bis 5, dadurch gekennzeichnet, dass zu den zweiten Mitteln ein Potentiometer (KU) gehört, welcher von besagter Interphasenspannung, nach deren Gleichrichtung, gespeist wird, und Mittel, um in einem Substraktions-Integrationsorgan (SI) eine Funktion der besagten Spannung vom Produkt aus dem Multiplikationsmittel (MU) abzuziehen.

7. Vorrichtung nach einem der Ansprüche 1 bis 6, dadurch gekennzeichnet, dass zu den dritten Mitteln ein Potentiometer ($P_2$) gehört, welcher einen Bruchteil einer konstanten Spannung entnimmt und Mittel, um im Substraktions-Integrationsorgan (SI) die besagte konstante Spannung vom Produkt aus dem Multiplikationsorgan (MU) abzuziehen.

8. Vorrichtung nach einem der Ansprüche 1 bis 7, dadurch gekennzeichnet, dass das Ergebnis der Integration, korrigiert durch die Einwirkung der vierten Mittel, mit dem Potential der Masse verglichen wird, in einem Vergleichsmittel (CP), welches an seinem Ausgang mit einem Mittel ($LED_1$, $LED_2$) zur Anzeige des Nullwertes des besagten korrigierten Ergebnisses vorgesehen ist.

9. Vorrichtung nach Anspruch 8, dadurch gekennzeichnet, dass besagtes Vergleichsmittel (CP) ausserdem so angelegt ist, dass es das Ergebnis der Integration mit einer Referenzspannung ($V_r$) vergleichen kann.

# Fig. 1

# Fig. 2